(19) Europäisches Patentamt
European Patent Office
Office européen des brevets

(11) EP 3 566 099 B1

(12) # EUROPEAN PATENT SPECIFICATION

(45) Date of publication and mention of the grant of the patent:
**24.02.2021 Bulletin 2021/08**

(21) Application number: **17830076.0**

(22) Date of filing: **21.12.2017**

(51) Int Cl.:
***G03F 7/029*** *(2006.01)* ***B41C 1/10*** *(2006.01)*
***G03F 7/032*** *(2006.01)* ***G03F 7/033*** *(2006.01)*
***G03F 7/105*** *(2006.01)*

(86) International application number:
**PCT/US2017/067769**

(87) International publication number:
**WO 2018/128830 (12.07.2018 Gazette 2018/28)**

(54) **NEGATIVE-WORKING LITHOGRAPHIC PRINTING PLATE PRECURSOR AND USE**

NEGATIV ARBEITENDER LITHOGRAPHIE-DRUCKPLATTENVORLÄUFER UND VERWENDUNG

PRÉCURSEUR DE PLAQUE D’IMPRESSION LITHOGRAPHIQUE À ACTION NÉGATIVE ET SON UTILISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.01.2017 US 201715397847**

(43) Date of publication of application:
**13.11.2019 Bulletin 2019/46**

(73) Proprietor: **Eastman Kodak Company**
**Rochester, NY 14650-2201 (US)**

(72) Inventors:
- **VIEHMANN, Philipp**
  **Rochester, NY 14650 (US)**
- **SIMPSON, Christopher D.**
  **Rochester, NY 14650 (US)**
- **WERNER, Saija**
  **Rochester, NY 14650 (US)**

(74) Representative: **Vossius & Partner**
**Patentanwälte Rechtsanwälte mbB**
**Siebertstrasse 3**
**81675 München (DE)**

(56) References cited:
**WO-A1-2008/036170 WO-A1-2010/033182**
**WO-A1-2010/096147 US-A1- 2007 275 322**

- **KESHENG FENG ET AL: "Synthesis and study of iodonium borate salts as photoinitiators", JOURNAL OF POLYMER SCIENCE, PART A: POLYMER CHEMISTRY, JOHN WILEY & SONS, INC, vol. 36, no. 10, 30 July 1998 (1998-07-30) , pages 1667-1677, XP002456415, ISSN: 0887-624X, DOI: 10.1002/(SICI)1099-0518(19980730)36:10<1667::AID-POLA20>3.0.CO;2-D**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 566 099 B1

## Description

### FIELD OF THE INVENTION

This invention relates to a negative-working lithographic printing plate precursor that can be imaged using infrared radiation and processed to provide a lithographic printing plate with improved printout characteristics. This invention also relates to a method for preparing lithographic printing plates from such precursors.

### BACKGROUND OF THE INVENTION

In lithographic printing, lithographic ink receptive regions, known as image areas, are generated on a hydrophilic surface of a planar substrate. When the printing plate surface is moistened with water and a lithographic printing ink is applied, hydrophilic regions retain the water and repel the lithographic printing ink, and the lithographic ink receptive image regions accept the lithographic printing ink and repel the water. The lithographic printing ink is transferred to the surface of a material upon which the image is to be reproduced, perhaps with the use of a blanket roller.

Negative-working lithographic printing plate precursors useful to prepare lithographic printing plates typically comprise a negative-working radiation-sensitive imageable layer disposed over the hydrophilic surface of a substrate. Such an imageable layer includes radiation-sensitive components that can be dispersed in a suitable matrix material. After the precursor is imagewise exposed to suitable radiation to form exposed regions and non-exposed regions, the non-exposed regions of the imageable layer are removed by a suitable developer, revealing the underlying hydrophilic surface of the substrate. The exposed regions of the imageable layer that are not removed are lithographic ink-receptive, and the hydrophilic substrate surface revealed by the developing process accept water and aqueous solutions such as a fountain solution, and repel lithographic printing ink.

Radiation-sensitive photopolymerizable compositions used in negative-working lithographic printing plate precursors typically comprise free-radically polymerizable components, one or more radiation absorbers, an initiator composition, and optionally one or more polymeric binders.

In recent years, there has been an emphasis in the industry for simplification of the lithographic printing plate making process, including an omission of the pre-development heating step (preheat) and by carrying out development on-press (DOP) using lithographic printing ink, fountain solution, or both, to remove unwanted coating materials on the lithographic printing plate precursors. Due to potential risks for press contamination, printing plate precursors designed for DOP usually have no oxygen barrier (protective) layer or such layer is present at a low coverage. Lithographic printing plate precursors designed for DOP typically need special IR photoinitiators such as diaryl iodonium salts having tetraphenyl borate anions that are even more efficient than conventional diaryl iodonium salts, as well as high initiator concentration in the infrared radiation-sensitive composition and imageable layer.

For example, U.S. Patent 7,524,614 (Tao et al.) describes lithographic printing plate precursors designed for DOP, which precursors contain suitable amounts of diaryliodonium borates including those having tetraaryl borate anions. Similar radiation-sensitive compositions and lithographic printing plates precursors are also described in U.S. Patent Application Publication 2011/0003123 (Simpson et al.).

Imaged lithographic printing plate precursors are normally visually inspected to make sure the desired image has been obtained. For precursors designed for processing off-press in a suitable developer, this inspection can occur easily before the lithographic printing plate is mounted on a printing press. A colorant is normally added to the imageable layer composition to facilitate this inspection.

For imaged precursors that are designed for DOP, the image is not as easily identified. Adding a colorant to the on-press developable imageable layer compositions can compromise shelf-life, on-press developability, or imaging sensitivity, and the colorant may contaminate lithographic printing inks. The industry has approached this problem in various ways. For example, U.S. Patent Application Publication 2009/0047599 (Home et al.) describes the use of a spirolactone or spirolactam colorant precursor that provides a visual image, commonly known as "print-out" (PO) as a result of an acid formed during the imaging process.

However, when iodonium salts having borate anions are used at desired high concentrations, the choice of the iodonium salt can have significant influence on PO of the lithographic printing plate precursor. As poor PO leads to reduced readability of an exposed lithographic printing plate precursor, thus compromising the work flow, it is desired to optimize the PO. The present invention is directed to that problem.

### SUMMARY OF THE INVENTION

The present invention provides a lithographic printing plate precursor comprising:

a substrate comprising a hydrophilic surface;

an infrared radiation-sensitive imageable layer that is disposed on the hydrophilic surface of the substrate, the infrared radiation-sensitive imageable layer comprising:

one or more free radically polymerizable components,
an initiator composition that provides free radicals upon exposure of the infrared radiation-sensitive imageable layer to infrared radiation,
one or more infrared radiation absorbers, and
optionally, a polymeric binder different from the one or more free radically polymerizable components; and

optionally, a protective layer disposed over the infrared radiation-sensitive imageable layer;
wherein the initiator composition comprises an iodonium tetraaryl borate that is represented by the following formula (I):

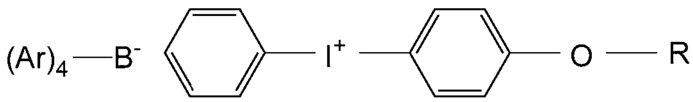

(I)

wherein Ar is independently unsubstituted phenyl or naphthyl groups, or substituted phenyl or naphthyl groups each having one or more electron-donating substituents; and R is a linear or branched organic group comprising 0 to 3 oxygen atoms and 2 to 5 carbon atoms, provided that R is directly attached to the oxygen atom with one of the carbon atoms.

This invention also provides a method for forming a lithographic printing plate, comprising:

imagewise exposing a lithographic printing plate precursor according to any embodiment of this invention with infrared radiation, to provide imagewise exposed regions and non-imagewise exposed regions in the infrared radiation-sensitive imageable layer, and
removing the non-imagewise exposed regions of the infrared radiation-sensitive imageable layer.

The present invention addresses the problem noted above concerning insufficient print-out (PO) by using an initiator composition that comprises one or more iodonium tetraaryl borates from a selected class of compounds defined by formula (I). It has been found that such compounds provide optimal PO without diminishing any of the other characteristics required for the on-press developable precursors such as on-press developability, imaging sensitivity, and printing press life.

Further advantages and benefits of the present invention will be evident from the teaching and working Examples provided below.

## DETAILED DESCRIPTION OF THE INVENTION

The following discussion is directed to various embodiments of the present invention and while some embodiments can be desirable for specific uses, the disclosed embodiments should not be interpreted or otherwise considered to limit the scope of the present invention, as claimed below. In addition, one skilled in the art will understand that the following disclosure has broader application than is explicitly described in the discussion of any embodiment.

### Definitions

As used herein to define various components of the hydrophilic coating formulation, radiation-sensitive imageable layer formulation, protective layer formulation, and other materials used in the practice of this invention, unless otherwise indicated, the singular forms "a," "an," and "the" are intended to include one or more of the components (that is, including plurality referents).

Each term that is not explicitly defined in the present application is to be understood to have a meaning that is commonly accepted by those skilled in the art. If the construction of a term would render it meaningless or essentially meaningless in its context, the term should be interpreted to have a standard dictionary meaning.

The use of numerical values in the various ranges specified herein, unless otherwise expressly indicated otherwise, are considered to be approximations as though the minimum and maximum values within the stated ranges

were both preceded by the word "about." In this manner, slight variations above and below the stated ranges may be useful to achieve substantially the same results as the values within the ranges. In addition, the disclosure of these ranges is intended as a continuous range including every value between the minimum and maximum values as well as the end points of the ranges.

Unless the context indicates otherwise, when used herein, the terms "negative-working, infrared radiation-sensitive lithographic printing plate precursor," "precursor," and "lithographic printing plate precursor" are meant to be equivalent references to embodiments of the present invention.

The term "support" is used herein to refer to an aluminum-containing material (sheet, web, strip, sheet, foil, or other form) that can be then treated or coated to prepare a "substrate" that refers to a hydrophilic article having a hydrophilic planar surface upon which various layers, including a hydrophilic anodic oxide layer, an infrared radiation-sensitive imageable layer, and an optional protective layer are disposed.

As used herein, the term "infrared radiation absorber" refers to a compound or material that absorbs electromagnetic radiation in the infrared region and typically refers to compounds or materials that have an absorption maximum in the infrared region.

As used herein, the term "infrared region" refers to radiation having a wavelength of at least 750 nm and higher. In most instances, the term "infrared" is used to refer to the "near-infrared" region of the electromagnetic spectrum that is defined herein to be at least 750 nm and up to and including 1400 nm.

For clarification of definitions for any terms relating to polymers, reference should be made to "Glossary of Basic Terms in Polymer Science" as published by the International Union of Pure and Applied Chemistry ("IUPAC"), Pure Appl. Chem. 68, 2287-2311 (1996). However, any definitions explicitly set forth herein should be regarded as controlling.

As used herein, the term "polymer" is used to describe compounds with relatively large molecular weights formed by linking together many small reacted monomers. As the polymer chain grows, it folds back on itself in a random fashion to form coiled structures. With the choice of solvents, a polymer can become insoluble as the chain length grows and become polymeric particles dispersed in the solvent medium. These particle dispersions can be very stable and useful in infrared radiation-sensitive imageable layers described for use in the present invention. In this invention, unless indicated otherwise, the term "polymer" refers to a non-crosslinked material. Thus, crosslinked polymeric particles differ from the non-crosslinked polymeric particles in that the latter can be dissolved in certain organic solvents of good solvating property whereas the crosslinked polymeric particles may swell but do not dissolve in the organic solvent because the polymer chains are connected by strong covalent bonds.

The term "copolymer" refers to polymers composed of two or more different repeating or recurring units that are arranged along the polymer backbone.

The term "backbone" refers to the chain of atoms in a polymer to which a plurality of pendant groups can be attached. An example of such a backbone is an "all carbon" backbone obtained from the polymerization of one or more ethylenically unsaturated polymerizable monomers.

Recurring units in polymeric binders described herein are generally derived from the corresponding ethylenically unsaturated polymerizable monomers used in a polymerization process, which ethylenically unsaturated polymerizable monomers can be obtained from various commercial sources or prepared using known chemical synthetic methods.

As used herein, the term "ethylenically unsaturated polymerizable monomer" refers to a compound comprising one or more ethylenically unsaturated (-C=C-) bonds that are polymerizable using free radical or acid-catalyzed polymerization reactions and conditions. It is not meant to refer to chemical compounds that have only unsaturated -C=C- bonds that are not polymerizable under these conditions.

Unless otherwise indicated, the term "weight %" refers to the amount of a component or material based on the total solids of a composition, formulation, or layer. Unless otherwise indicated, the percentages can be the same for either a dry layer or the total solids of the formulation or composition.

As used herein, the term "layer" or "coating" can consist of one disposed or applied layer or a combination of several sequentially disposed or applied layers. If a layer is considered infrared radiation-sensitive and negative-working, it is both sensitive to infrared radiation (as described above for "infrared radiation-absorber") and negative-working in the formation of lithographic printing plates.

## Uses

The lithographic printing plate precursors of the present invention are useful for forming lithographic printing plates for lithographic printing using a lithographic printing ink and fountain solution. These precursors are prepared with the structure and components described as follows. In addition, the present invention is useful for preparing such lithographic printing plates by imagewise exposing and processing the exposed precursor off-press using a suitable developer or on-press using a lithographic printing ink, a fountain solution, or a combination of a lithographic printing ink and a fountain solution as described below.

## Substrate

The substrate that is present in the precursors of this invention generally has a hydrophilic imaging-side planar surface, or at least a surface that is more hydrophilic than the applied infrared radiation-sensitive imageable layer on the imaging side of the substrate. The substrate comprises a support that can be composed of any material that is conventionally used to prepare lithographic printing plate precursors.

One useful substrate is composed of an aluminum-containing support that can be treated using techniques known in the art, including roughening of some type by physical (mechanical) graining, electrochemical graining, or chemical graining, which is followed by anodizing. Anodizing is typically done using phosphoric or sulfuric acid and conventional procedures to form a desired hydrophilic aluminum oxide (or anodic oxide) layer or coating on the aluminum-containing support, which aluminum oxide (anodic oxide) layer can comprise a single layer or a composite of multiple layers having multiple pores with varying depths and shapes of pore openings. Such processes thus provide an anodic oxide layer underneath an infrared radiation-sensitive imageable layer that can be provided as described below. A discussion of such pores and a process for controlling their width is described for example in U.S. Patent Publication 2013/0052582 (Hayashi).

Sulfuric acid anodization of the aluminum support generally provides an aluminum (anodic) oxide weight (coverage) on the surface of at least 1 $g/m^2$ and up to and including 5 $g/m^2$ and more typically of at least 2 $g/m^2$ and up to and including 4 $g/m^2$. Phosphoric acid anodization generally provides an aluminum (anodic) oxide weight on the surface of from at least 0.5 $g/m^2$ and up to and including 5 $g/m^2$ and more typically of at least 1 $g/m^2$ and up to and including 3 $g/m^2$.

An anodized aluminum support can be treated further to seal the anodic oxide pores or to further hydrophilize its surface, or both, using known post-anodic treatment (PAT) processes, such as post-treatments in aqueous solutions of poly(vinyl phosphonic acid) (PVPA), vinyl phosphonic acid copolymers, poly [(meth)acrylic acid] or its alkali metal salts, or acrylic acid copolymers or their alkali metal salts, mixtures of phosphate and fluoride salts, or sodium silicate. The PAT process materials can also comprise unsaturated double bonds to provide mechanical strength of the resulting treatment. Such unsaturated double bonds can be provided in low molecular weight materials or they can be present within side chains of polymers. Useful post-treatment processes include dipping the substrate with rinsing, dipping the substrate without rinsing, and various coating techniques such as extrusion coating.

For example, as noted in the cited Hayashi publication, an anodized substrate can be treated with an alkaline or acidic pore-widening solution to provide an anodic oxide layer containing columnar pores so that the diameter of the columnar pores at their outermost surface is at least 90% of the average diameter of the columnar pores. In some embodiments, the treated substrate can comprise a hydrophilic layer disposed directly on a grained, anodized, and post-treated aluminum-containing support, and such hydrophilic layer can comprise a non-crosslinked hydrophilic polymer having carboxylic acid side chains.

The thickness of a substrate can be varied but should be sufficient to sustain the wear from printing and thin enough to wrap around a printing form. Useful embodiments include a treated aluminum foil having a thickness of at least 100 $\mu$m and up to and including 700 $\mu$m. The backside (non-imaging side) of the substrate can be coated with antistatic agents, a slipping layer, or a matte layer to improve handling and "feel" of the precursor.

As discussed in more detail below, the substrate is generally formed as a continuous roll (or continuous web) of sheet material that is suitably coated with an infrared radiation-sensitive imageable layer formulation and optionally a protective layer formulation, followed by slitting or cutting (or both) to size to provide individual lithographic printing plate precursors. Typically, the cut individual precursors have a planar or generally flat rectangular shape.

## Infrared Radiation-Sensitive Imageable Layer

The precursors of the present invention can be formed by suitable application of a negative-working infrared radiation-sensitive composition as described below to a suitable substrate (as described above) to form an infrared radiation-sensitive imageable layer that is negative-working on that substrate. In general, the infrared radiation-sensitive composition (and resulting infrared radiation-sensitive imageable layer) comprises one or more free radically polymerizable components, one or more infrared radiation absorbers, and an initiator composition that provides free radicals upon exposure to imaging infrared radiation as essential components, and optionally, a polymeric binder different from the one or more free radically polymerizable components, all of which essential and optional components are described in more detail below. There is generally only a single infrared radiation-sensitive imageable layer in the precursor. It is generally the outermost layer in the precursor, but in some embodiments, there can be an outermost water-soluble hydrophilic protective layer (also known as a topcoat or oxygen barrier layer) disposed over the infrared radiation-sensitive imageable layer.

It is particularly useful to design the components of the infrared radiation-sensitive imageable layer in such a manner (types and forms of chemical compounds and amounts of each) that this infrared radiation-sensitive imageable layer is on-press developable using a lithographic printing ink, a fountain solution, or a combination of a lithographic

printing ink and a fountain solution. More details of on-press developability are described below.

The infrared radiation-sensitive composition (and infrared radiation-sensitive imageable layer prepared therefrom) comprises one or more free radically polymerizable components, each of which contains one or more free radically polymerizable groups (and two or more of such groups in some embodiments) that can be polymerized using free radical initiation. In some embodiments, the infrared radiation-sensitive imageable layer comprises two or more free radically polymerizable components having the same or different numbers of free radically polymerizable groups in each molecule.

Useful free radically polymerizable components can contain one or more free radical polymerizable monomers or oligomers having one or more addition polymerizable ethylenically unsaturated groups (for example, two or more of such groups). Similarly, crosslinkable polymers having such free radically polymerizable groups can also be used. Oligomers or prepolymers, such as urethane acrylates and methacrylates, epoxide acrylates and methacrylates, polyester acrylates and methacrylates, poly ether acrylates and methacrylates, and unsaturated polyester resins can be used. In some embodiments, the free radically polymerizable component comprises carboxyl groups.

It is possible for one or more free radically polymerizable components to have large enough molecular weight to enhance the mechanical properties of the radiation-sensitive imageable layer and thus make the corresponding lithographic printing plate precursors suitable for transportation in typical packaging and for handling during normal prepress operation. In such embodiments, a separate non-polymerizable or non-crosslinkable polymer binder (described below) is not necessary but may still be present.

Free radically polymerizable components include urea urethane (meth)acrylates or urethane (meth)acrylates having multiple (two or more) polymerizable groups. Mixtures of such compounds can be used, each compound having two or more unsaturated polymerizable groups, and some of the compounds having three, four, or more unsaturated polymerizable groups. For example, a free radically polymerizable component can be prepared by reacting DESMODUR® N100 aliphatic polyisocyanate resin based on hexamethylene diisocyanate (Bayer Corp., Milford, Conn.) with hydroxy ethyl acrylate and pentaerythritol triacrylate. Useful free radically polymerizable compounds include NK Ester A-DPH (dipentaerythritol hexaacrylate) that is available from Kowa American, and Sartomer 399 (dipentaerythritol pentaacrylate), Sartomer 355 (di-trimethylolpropane tetraacrylate), Sartomer 295 (pentaerythritol tetraacrylate), and Sartomer 415 [ethoxylated (20)trimethylolpropane triacrylate] that are available from Sartomer Company, Inc.

Numerous other free radically polymerizable components are known in the art and are described in considerable literature including Photoreactive Polymers: The Science and Technology of Resists, A Reiser, Wiley, New York, 1989, pp. 102-177, by B.M. Monroe in Radiation Curing: Science and Technology, S.P. Pappas, Ed., Plenum, New York, 1992, pp. 399-440, and in "Polymer Imaging" by A.B. Cohen and P. Walker, in Imaging Processes and Material, J.M. Sturge et al. (Eds.), Van Nostrand Reinhold, New York, 1989, pp. 226-262. For example, useful free radically polymerizable components are also described in EP 1,182,033A1 (Fujimaki et al.), beginning with paragraph [0170], and in U.S Patents 6,309,792 (Hauck et al.), 6,569,603 (Furukawa), and 6,893,797 (Munnelly et al.). Other useful free radically polymerizable components include those described in U.S. Patent Application Publication 2009/0142695 (Baumann et al.), which radically polymerizable components include 1H-tetrazole groups.

The one or more free radically polymerizable components are generally present in an infrared radiation-sensitive imageable layer in an amount of at least 10 weight % and up to and including 70 weight %, or typically of at least 20 weight % and up to and including 50 weight %, all based on the total dry weight of the infrared radiation-sensitive imageable layer.

In addition, the infrared radiation-sensitive imageable layer also comprises one or more infrared radiation absorbers to provide desired infrared radiation sensitivity or to convert radiation to heat, or both.

The total amount of one or more radiation absorbers is at least 0.5 weight % and up to and including 30 weight %, or typically of at least 1 weight % and up to and including 15 weight %, based on the total dry weight of the infrared radiation-sensitive imageable layer.

Useful infrared radiation absorbers can be pigments or infrared radiation absorbing dyes. Suitable dyes also can be those described in for example, U.S. Patents 5,208,135 (Patel et al.), 6,153,356 (Urano et al.), 6,309,792 (Hauck et al.), 6,569,603 (Furukawa), 6,797,449 (Nakamura et al.), 7,018,775 (Tao), 7,368,215 (Munnelly et al.), 8,632,941 (Balbinot et al.), and U.S. Patent Application Publication 2007/056457 (Iwai et al.). In some infrared radiation-sensitive embodiments, it is desirable that at least one infrared radiation absorber in the infrared radiation-sensitive imageable layer be a cyanine dye comprising a tetraarylborate anion such as a tetraphenylborate anion. Examples of such dyes include those described in United States Patent Application Publication 2011/003123 (Simpson et al.).

In addition to low molecular weight IR-absorbing dyes, IR dye chromophores bonded to polymers can be used as well. Moreover, IR dye cations can be used as well, that is, the cation is the IR absorbing portion of the dye salt that ionically interacts with a polymer comprising carboxy, sulfo, phospho, or phosphono groups in the side chains.

The infrared radiation-sensitive imageable layer also includes an initiator composition that provides free radicals upon exposure of the radiation-sensitive imageable layer to infrared radiation to initiate the polymerization of the one or more free radically polymerizable components. The initiator composition can be a single compound or a combination or system of a plurality of compounds as long as it includes a least one iodonium tetraaryl borate as described below.

It is essential for achieving the desired improvements for the present invention that the initiator composition comprises one or more iodonium salts, at least one of which is represented by the following formula (I), so that at least 50 mol % of the total iodonium salts is composed of one or more of the formula (I) compounds. In some embodiments, all of the one or more different iodonium tetraaryl borates present in the infrared radiation-sensitive imageable layer are represented by the following formula (I):

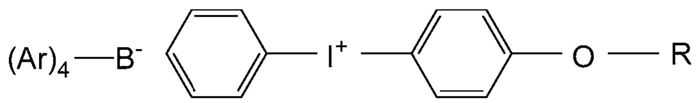

(I)

In formula (I), Ar represents independently unsubstituted phenyl or naphthyl groups, or independently substituted phenyl or naphthyl groups each having one or more electron-donating substituents. Thus, the four Ar groups can be the same in most embodiments of this invention (such as the same substituted or unsubstituted phenyl groups), or they can represent 2, 3, or 4 different phenyl or naphthyl groups that are unsubstituted or substituted as noted. Useful electron-donating substituents include but are not limited to, linear and branched alkyl, cycloalkyl, phenyl, alkoxy, dialkylamino, and vinyl groups. Such substituents do not include halogen atoms such as fluorine atoms. In most useful embodiments, each of the four Ar groups is an unsubstituted phenyl group.

In formula (I), R is a linear or branched organic group comprising 0, 1, 2, or 3 oxygen atoms, and 2, 3, 4, or 5 carbon atoms, provided that R is attached to the oxygen in formula (I) with one of the carbon atoms. More particularly, the linear or branched R organic group can comprise 0, 1, or 2 oxygen atoms and 3 or 4 carbon atoms. In most embodiments, the organic group R contains no atoms other than carbon, oxygen, and hydrogen atoms.

For example, when R contains no oxygen atoms, the linear or branched organic group is a hydrocarbon group including but not limited to, ethyl, *n*-propyl, *n*-butyl, *n*-pentyl, *iso*-propyl, *iso*-butyl, *iso*-pentyl, *sec*-butyl, *sec*-pentyl, *t*-butyl, 2-methylbutyl, neopentyl, 1-ethylpropyl, 1,1-dimethylpropyl, 1,2-dimethylpropyl, vinyl, and allyl.

When R comprises 1 to 3 oxygen atoms, they can be present within the organic group in any chemically possible position as long as the organic group is connected to the oxygen atom of formula (I) with one of the carbon atoms. For example, representative linear or branched organic groups include but are not limited to, $CH_2CH_2OCH_3$, $-(CH_2)_3-OCH_3$, $-(CH_2)_4-OCH_3$, $-CH(CH_3)CH_2OCH_3$, $-CH_2CH(CH_3)OCH_3$, $-CH_2CH_2OCH_2CH_3$ $-CH_2CH_2OC(=O)CH=CH_2$, $-C(=O)CH=CH_2$, $-C(=O)C(CH_3)=CH_2$, $-C(=O)CH_2CH=CH_2$, $-C(=O)(CH_2)_2CH=CH_2$, and other organic groups that would be readily apparent to one skilled in the art.

In many embodiments, R is a linear or branched hydrocarbon group having 3 or 4 carbon atoms (representative groups defined above), or a linear or branched oxyhydrocarbon group having 3 or 4 carbon atoms and 1 or 2 oxygen atoms (representative groups defined above). A particularly useful R group in the practice of this invention is an *n*-butyl group.

The one or more iodonium tetraaryl borate compounds represented by formula (I) are generally present in the infrared radiation-sensitive imageable layer sufficient to provide one or more polymerization initiators in an amount of at least 1 weight % and up to and including 25 weight %, or typically of at least 5 weight % and up to and including 15 weight %, or even of at least 6.5 weight % and up to and including 13 weight %, all based on the total dry weight of the infrared radiation-sensitive imageable layer.

It is optional but desirable in many embodiments that the infrared radiation-sensitive imageable layer further comprise a polymeric material that acts as a polymeric binder for all of the materials in the noted layer. Such "polymer binders" are different from the one or more free radically polymerizable components described above, and are generally non-polymerizable and non-crosslinkable.

Such polymeric binders can be selected from a number of polymeric binder materials known in the art including polymers comprising recurring units having side chains comprising polyalkylene oxide segments such as those described in for example, U.S. Patent 6,899,994 (Huang et al.). Other useful polymeric binders comprise two or more types of recurring units having different side chains comprising polyalkylene oxide segments as described in for example WO Publication 2015-156065 (Kamiya et al.). Some of such polymeric binders can further comprise recurring units having pendant cyano groups as those described in for example U.S. Patent 7,261,998 (Hayashi et al.).

Some useful polymeric binders are present in particulate form, that is, in the form of discrete particles (non-agglomerated particles). Such discrete particles can have an average particle size of at least 10 nm and up to and including 1500 nm, or typically of at least 80 nm and up to and including 600 nm, and that are generally distributed uniformly within the infrared radiation-sensitive imageable layer. One or more other useful polymeric binders can be present in the form of particles having an average particle size of at least 50 nm and up to and including 400 nm. Average particle size can be determined by various known methods including measuring the particles in electron scanning

microscope images, and averaging a set number of measurements.

In some embodiments, the polymeric binder is present in the form of particles having an average particle size that is less than the average dry thickness (t) of the infrared radiation-sensitive imageable layer. The average dry thickness (t) in micrometers (μm) is calculated by the following Equation:

$$t = w/r$$

wherein w is the dry coating coverage of the infrared radiation-sensitive imageable layer in $g/m^2$ and r is 1 $g/cm^3$. For example, in such embodiments, the polymeric binder can comprise at least 0.05% and up to and including 80%, or more likely at least 10% and up to and including 50%, of the infrared radiation-sensitive imageable layer.

The polymeric binders also can have a backbone comprising multiple (at least two) urethane moieties as well as pendant groups comprising the polyalkylenes oxide segments.

Other useful polymeric binders also include those that comprise polymerizable groups such as acrylate ester group, methacrylate ester group, vinyl aryl group and allyl group and those that comprise alkali soluble groups such as carboxylic acid. Some of these useful polymeric binders are described in U.S. Patent Application Publication 2015/0099229 (Simpson et al.) and U.S. Patent 6,916,595 (Fujimaki et al.).

Useful polymeric binders generally have a weight average molecular weight (Mw) of at least 2,000 and up to and including 500,000, or at least 20,000 and up to and including 300,000, as determined by Gel Permeation Chromatography (polystyrene standard).

Useful polymeric binders can be obtained from various commercial sources or they can be prepared using known procedures and starting materials, as described for example in publications described above.

When present, the total polymeric binders can be present in the infrared radiation-sensitive imageable layer in an amount of at least 10 weight % and up to and including 70 weight %, or more likely in an amount of at least 20 weight % and up to and including 50 weight %, based on the total dry weight of the infrared radiation-sensitive imageable layer.

Other polymeric materials known in the art can be present in the infrared radiation-sensitive imageable layer as addenda and such polymeric materials are generally more hydrophilic or more hydrophobic than the polymeric binders described above. Example of such hydrophilic "secondary" polymeric binders include but are not limited to, cellulose derivatives such as hydroxypropyl cellulose, carboxymethyl cellulose, and polyvinyl alcohol with various degrees of saponification. More hydrophobic secondary polymeric binders are less developable than the polymeric binders described above and typically have an acid value less than 20 mg KOH/g for all acidic groups having a pKa below 7 and their corresponding salts. Such hydrophobic polymeric binders typically contain less than 10 weight %, more typically less than 5 weight%, segments that contribute to the hydrophilicity of the binder and are selected from the group consisting of hydroxyl group, $-(CH_2CH_2-O)-$ and $-C(=O)NH_2$. Examples of such hydrophobic polymeric binders include but are not limited to, poly(methyl methacrylate), poly(benzyl methacrylate), and polystyrene.

Additional additives to the infrared radiation-sensitive imageable layer can include dye precursors and color developers as are known in the art. Useful organic dyes or organic dye precursors include but are not limited to, phthalide and fluoran leuco dyes having a lactone skeleton with an acid dissociatable lactone skeleton, such as those described in U.S. Patent 6,858,374 (Yanaka). Such additives can be used as print-out colorants and can be present in an amount of at least 1 weight % and up to and including 10 weight %, based on the total dry weight of the infrared radiation-sensitive imageable layer. Other useful print-out colorants are known in the art and can include azo dyes, triarylmethane dyes, cyanine dyes, and spirolactone or spirolactam colorants as described for example in U.S. Patent Application Publication 2009/0047599 (noted above).

The infrared radiation-sensitive imageable layer can include crosslinked polymer particles having an average particle size of at least 2 μm, or of at least 4 μm, and up to and including 20 μm as described for example in U.S. Serial No. 14/642,876 (filed March 10, 2015 by Hayakawa et al.) and in U.S. Patents 8,383,319 (Huang et al.) and 8,105,751 (Endo et al.). Such crosslinked polymeric particles can be present only in the infrared radiation-sensitive imageable layer, only in the protective layer when present (described below), or in both the infrared radiation-sensitive imageable layer and the protective layer when present.

The infrared radiation-sensitive imageable layer can also include a variety of other optional addenda including but not limited to, dispersing agents, humectants, biocides, plasticizers, surfactants for coatability or other properties, viscosity builders, pH adjusters, drying agents, defoamers, preservatives, antioxidants, development aids, rheology modifiers, or combinations thereof, or any other addenda commonly used in the lithographic art, in conventional amounts. The infrared radiation-sensitive imageable layer can also include a phosphate (meth)acrylate having a molecular weight generally greater than 250 as described in U.S. Patent 7,429,445 (Munnelly et al.).

## Hydrophilic Protective Layer

While in some embodiments of the present invention, the infrared radiation-sensitive imageable layer is the outermost layer with no layers disposed thereon, it is possible that the precursors can be designed with a hydrophilic protective layer (also known in the art as a hydrophilic overcoat, oxygen-barrier layer, or topcoat) disposed directly on the infrared radiation-sensitive imageable layer (no intermediate layers between these two layers). Such precursors can be developed on-press as well as off-press using any suitable developer as described below.

When present, this hydrophilic protective layer is generally the outermost layer of the precursor and thus, when multiple precursors are stacked one on top of the other, the hydrophilic protective layer of one precursor can be in contact with the backside of the substrate of the precursor immediately above it, where no interleaving paper is present.

Such hydrophilic protective layers can comprise one or more film-forming water-soluble polymeric binders in an amount of at least 60 weight % and up to and including 100 weight %, based on the total dry weight of the hydrophilic protective layer. Such film-forming water-soluble (or hydrophilic) polymeric binders can include a modified or unmodified poly(vinyl alcohol) having a saponification degree of at least 30%, or a degree of at least 75%, or a degree of at least 90%, and a degree of up to and including 99.9%.

Further, one or more acid-modified poly(vinyl alcohol)s can be used as film-forming water-soluble (or hydrophilic) polymeric binders in the hydrophilic protective layer. For example, at least one modified poly(vinyl alcohol) can be modified with an acid group selected from the group consisting of carboxylic acid, sulfonic acid, sulfuric acid ester, phosphonic acid, and phosphoric acid ester groups. Examples of such materials include but are not limited to, sulfonic acid-modified poly(vinyl alcohol), carboxylic acid-modified poly(vinyl alcohol), and quaternary ammonium salt-modified poly(vinyl alcohol), glycol-modified poly(vinyl alcohol), or combinations thereof.

The optional hydrophilic overcoat can also include crosslinked polymer particles having an average particle size of at least 2 μm and as described for example in U.S. Serial No. 14/642,876 (filed March 10, 2015 by Hayakawa et al.) and in U.S. Patents 8,383,319 (Huang et al.) 8,105,751 (Endo et al.).

When present, the hydrophilic protective layer is provided at a dry coating coverage of at least 0.1 $g/m^2$ and up to but less than 4 $g/m^2$, and typically at a dry coating coverage of at least 0.15 $g/m^2$ and up to and including 2.5 $g/m^2$. In some embodiments, the dry coating coverage is as low as 0.1 $g/m^2$ and up to and including 1.5 $g/m^2$ or at least 0.1 $g/m^2$ and up to and including 0.9 $g/m^2$, such that the hydrophilic protective layer is relatively thin for easy removal during off-press development or on-press development.

The hydrophilic protective layer can optionally comprise organic wax particles dispersed, generally uniformly, within the one or more film-forming water-soluble (or hydrophilic) polymeric binders as described for example in U.S. Patent Application Publication 2013/0323643 (Balbinot et al.).

## Lithographic Printing Plate Precursors

The infrared radiation-sensitive lithographic printing plate precursors of the present invention can be provided in the following manner. An infrared radiation-sensitive imageable layer formulation comprising materials described above can be applied to a hydrophilic surface of a suitable substrate, usually in a continuous substrate roll or web, as described above using any suitable equipment and procedure, such as spin coating, knife coating, gravure coating, die coating, slot coating, bar coating, wire rod coating, roller coating, or extrusion hopper coating. Such formulation can also be applied by spraying onto a suitable substrate. Typically, once the infrared radiation-sensitive imageable layer formulation is applied at a suitable wet coverage, it is dried in a suitable manner known in the art to provide a desired dry coverage as noted below, thereby providing an infrared radiation-sensitive continuous article that can be in any suitable form such as a web that can be used to provide individual precursors using known manufacturing processes.

As noted above, before the infrared radiation-sensitive imageable layer formulation is applied, the substrate has been electrochemically grained and anodized as described above to provide a suitable hydrophilic anodic oxide layer on the outer surface of the aluminum-containing support, and the anodized surface usually has been post-treated with a hydrophilic polymer solution as described above. The conditions and results of these operations are well known in the art as described above in the Substrate section.

The manufacturing methods typically include mixing the various components needed for the infrared radiation-sensitive imageable layer chemistry in a suitable organic solvent or mixtures thereof [such as methyl ethyl ketone (2-butanone), methanol, ethanol, 1-methoxy-2-propanol, *iso*-propyl alcohol, acetone, γ-butyrolactone, *n*-propanol, tetrahydrofuran, and others readily known in the art, as well as mixtures thereof], applying the resulting infrared radiation-sensitive imageable layer formulation to the continuous substrate web, and removing the solvent(s) by evaporation under suitable drying conditions. After proper drying, the dry coating coverage of the infrared radiation-sensitive imageable layer on the continuous substrate web is generally at least 0.1 $g/m^2$ and up to and including 4 $g/m^2$ or at least 0.4 $g/m^2$ and up to and including 2 $g/m^2$ but other dry coverage amounts can be used if desired.

As described above, in some embodiments, a suitable aqueous-based hydrophilic protective layer formulation

can be applied to the dried infrared radiation-sensitive imageable layer using known coating and drying conditions, equipment, and procedures.

In practical manufacturing conditions, the result of these coating operations is a continuous web or roll of infrared radiation-sensitive lithographic printing plate precursor material having either only a single infrared radiation-sensitive imageable layer or both a single infrared radiation-sensitive imageable layer and a protective layer disposed on the infrared radiation-sensitive imageable layer.

Individual rectangular lithographic printing plate precursors are formed from this resulting continuous infrared radiation-sensitive web or roll by slitting and cutting-to-length ("CTL") slitting process creates one or more longitudinal strips from the continuous infrared radiation-sensitive web and is typically used to remove the unwanted edge regions of the continuous radiation-sensitive web and to create two or more strips, each of which has a width equal to one dimension of rectangular lithographic printing plate precursors. The cutting-to-length process is used to create a lateral cut across each strip at an interval equal to the other dimension of rectangular lithographic printing plate precursors, thereby forming individual precursors.

## Imaging (Exposing) Conditions

During use, an infrared radiation-sensitive lithographic printing plate precursor of this invention can be exposed to a suitable source of exposing infrared radiation depending upon the infrared radiation absorber present in the infrared radiation-sensitive imageable layer. The lithographic printing plate precursors can be imaged with infrared lasers that emit significant radiation within the range of at least 750 nm and up to and including 1400 nm, or of at least 800 nm and up to and including 1250 nm.

For example, imaging can be carried out using imaging or exposing radiation from an infrared radiation-generating laser (or array of such lasers). Imaging also can be carried out using imaging infrared radiation at multiple wavelengths at the same time if desired. The laser used to expose the precursor is usually a diode laser, because of the reliability and low maintenance of diode laser systems, but other lasers such as gas or solid-state lasers can also be used. The combination of power, intensity and exposure time for infrared radiation imaging would be readily apparent to one skilled in the art.

The imaging apparatus can be configured as a flatbed recorder or as a drum recorder, with the infrared radiation-sensitive lithographic printing plate precursor mounted to the interior or exterior cylindrical surface of the drum. An example of useful imaging apparatus is available as models of KODAK® Trendsetter platesetters (Eastman Kodak Company) and NEC AMZISetter X-series (NEC Corporation, Japan) that contain laser diodes that emit radiation at a wavelength of about 830 nm. Other suitable imaging apparatus includes the Screen PlateRite 4300 series or 8600 series platesetters (available from Screen USA, Chicago, IL) or thermal CTP platesetters from Panasonic Corporation (Japan) that operate at a wavelength of 810 nm.

Imaging energies can be at least 30 mJ/cm$^2$ and up to and including 500 mJ/cm$^2$ and typically at least 50 mJ/cm$^2$ and up to and including 300 mJ/cm$^2$ depending upon the sensitivity of the infrared radiation-sensitive imageable layer.

## Processing (Development) and Printing

After imagewise exposing, the exposed infrared radiation-sensitive lithographic printing plate precursors having exposed regions and non-exposed regions in the infrared radiation-sensitive imageable layer are processed in a suitable manner to remove the non-exposed regions and any hydrophilic protective layer if present.

Processing can be carried out off-press using any suitable developer in one or more successive applications (treatments or developing steps) of the same or different processing solution. Such one or more successive processing treatments can be carried out with exposed precursors for a time sufficient to remove the non-exposed regions of the infrared radiation-sensitive imageable layer to reveal the hydrophilic surface of the substrate, but not long enough to remove significant amounts of the exposed regions that have been hardened in the same layer. During lithographic printing, the revealed hydrophilic substrate surface repels inks while the remaining exposed regions accept lithographic printing ink.

Prior to such off-press processing, the exposed precursors can be subjected to a "pre-heating" process to further harden the exposed regions in the infrared radiation-sensitive imageable layer. Such optional pre-heating can be carried out using any known process and equipment generally at a temperature of at least 60°C and up to and including 180°C.

Following this optional pre-heating, or in place of the pre-heating, the exposed precursor can be washed (rinsed) to remove any hydrophilic protective layer that is present. Such optional washing (or rinsing) can be carried out using any suitable aqueous solution (such as water or an aqueous solution of a surfactant) at a suitable temperature and for a suitable time that would be readily apparent to one skilled in the art.

Useful developers can be ordinary water or can be formulated aqueous solutions. The formulated developers can comprise one or more components selected from surfactants, organic solvents, alkali agents, and surface protective agents. For example, useful organic solvents include the reaction products of phenol with ethylene oxide and propylene oxide [such as ethylene glycol phenyl ether (phenoxyethanol)], benzyl alcohol, esters of ethylene glycol and of propylene glycol with acids having 6 or less carbon atoms, and ethers of ethylene glycol, diethylene glycol, and of propylene glycol with alkyl groups having 6 or less carbon atoms, such as 2-ethylethanol and 2-butoxyethanol.

In some instances, an aqueous processing solution can be used off-press to both develop the imaged precursor by removing the non-exposed regions and also to provide a protective layer or coating over the entire imaged and developed (processed) precursor printing surface. In this embodiment, the aqueous solution behaves somewhat like a gum that is capable of protecting (or "gumming") the lithographic image on the printing plate against contamination or damage (for example, from oxidation, fingerprints, dust, or scratches).

After the described off-press processing and optional drying, the resulting lithographic printing plate can be mounted onto a printing press without any contact with additional solutions or liquids. It is optional to further bake the lithographic printing plate with or without blanket or flood-wise exposure to UV or visible radiation.

After off-press developing, printing can be carried out by putting the exposed and processed lithographic printing plate on a suitable printing press, and applying a lithographic printing ink and fountain solution to the printing surface of the lithographic printing plate in a suitable manner. The fountain solution is taken up by the surface of the hydrophilic substrate revealed by the exposing and processing steps, and the lithographic ink is taken up by the remaining (exposed) regions of the infrared radiation-sensitive imageable layer. The lithographic ink is then transferred to a suitable receiving material (such as cloth, paper, metal, glass, or plastic) to provide a desired impression of the image thereon. If desired, an intermediate "blanket" roller can be used to transfer the lithographic ink from the lithographic printing plate to the receiving material (for example, sheets of paper).

<u>On-Press Development and Printing:</u>

Alternatively, the lithographic printing plate precursors according to the present invention are on-press developable using a lithographic printing ink, a fountain solution, or a combination of a lithographic printing ink and a fountain solution. In such embodiments, an imaged infrared radiation-sensitive lithographic printing plate precursor according to the present invention is mounted onto a printing press and the printing operation is begun. The non-exposed regions in the infrared radiation-sensitive imageable layer are removed by a suitable fountain solution, lithographic printing ink, or a combination of both, when the initial printed impressions are made. Typical ingredients of aqueous fountain solutions include pH buffers, desensitizing agents, surfactants and wetting agents, humectants, low boiling solvents, biocides, antifoaming agents, and sequestering agents. A representative example of a fountain solution is Varn Litho Etch 142W + Varn PAR (alcohol sub) (available from Varn International, Addison, IL).

In a typical printing press startup with a sheet-fed printing machine, the dampening roller is engaged first and supplies fountain solution to the mounted imaged precursor to swell the exposed infrared radiation-sensitive imageable layer at least in the non-exposed regions. After a few revolutions, the inking rollers are engaged and they supply lithographic printing ink(s) to cover the entire printing surface of the lithographic printing plates. Typically, within 5 to 20 revolutions after the inking roller engagement, printing sheets are supplied to remove the non-exposed regions of the infrared radiation-sensitive imageable layer from the lithographic printing plate as well as materials on a blanket cylinder if present, using the formed ink-fountain emulsion.

On-press developability of the lithographic printing precursors is particularly useful when the precursor comprises one or more polymeric binders in the infrared radiation-sensitive imageable layer, at least one of which polymeric binders is present as particles having an average diameter of at least 50 nm and up to and including 400 nm.

## Examples

The following Examples are provided to illustrate the practice of this invention and are not meant to be limiting in any manner. Unless otherwise indicated, the materials used in the working examples were obtained from various commercial sources.

A substrate was prepared for the lithographic printing plate precursors in the following manner:
The surface of an aluminum sheet was subjected to an electrolytic roughening treatment using hydrochloric acid to provide an average roughness Ra of 0.5 μm. Then grained aluminum sheet was subjected to an anodizing treatment in an aqueous phosphoric acid solution to form an aluminum oxide film of about 500 nm in dry thickness, followed by post-treatment with a poly(acrylic acid) solution.

In infrared radiation-sensitive imageable layer was then applied to the substrate by coating the infrared radiation-sensitive imageable layer formulation having the components shown in the following TABLE I using a bar coater, to provide a dry coating weight of 0.9 $g/m^2$ after drying at 50°C for 60 seconds, and some components are defined below

in TABLE II.

TABLE I

| Component | Amount (grams) |
|---|---|
| Polymer dispersion | 0.747 |
| Hydroxypropyl methyl cellulose | 0.400 |
| Monomer 1 | 0.333 |
| Monomer 2 | 0.167 |
| IR dye 1 | 0.020 |
| Leuco Dye 1 | 0.023 |
| Surfactant 1 | 0.045 |
| Iodonium salt | (see TABLE II) |
| 1-Propanol | 3.27 |
| 2-Butanone | 1.60 |
| 1-Methoxy-2-propanol | 2.82 |
| δ-Butyrolactone | 0.10 |
| Water | 0.43 |

TABLE II

| | |
|---|---|
| Polymer dispersion | The polymer dispersion prepared according to Example 10 of EP 1,765,593, used as 23.5 weight % polymer in *n*-propanol/water at 80:20 weight ratio |
| Hydroxy propyl methyl cellulose | 5 weight % hydroxypropyl methyl cellulose polymer in water; the polymer is 30% methoxylated, 10% hydroxyl propoxylated and has a viscosity of 5 mPa sec in a 2% aqueous solution at 20°C. |
| Monomer 1 | Urethane acrylate prepared by reacting DESMODUR® N100 (from Bayer Corp., Milford, CT) with hydroxyethyl acrylate and pentaerythritol triacrylate at approximately 1:1.5:1.5 molar ratio (40 weight % in 2-butanone). |
| Monomer 2 | Ethoxylated (10 EO) Bisphenol A acrylate, 40 weight % in 2-butanone |
| IR dye 1 | 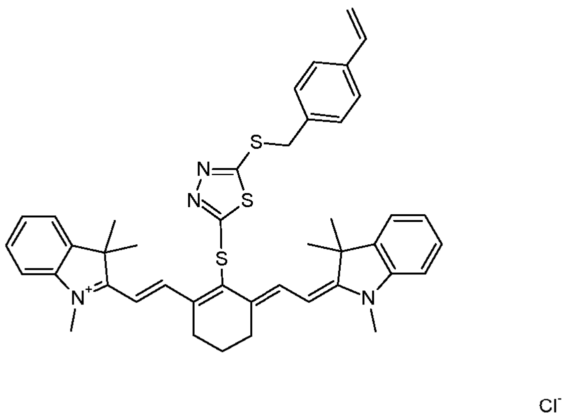 |

(continued)

| | |
|---|---|
| Leuco dye 1 | 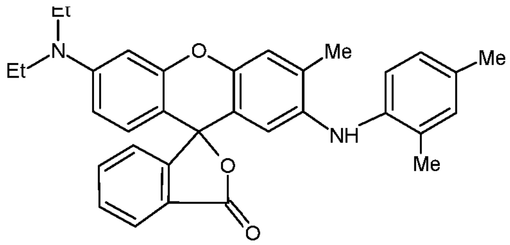 |
| Surfactant 1 | BYK® 302 from Byk Chemie, used as a 25 weight % solution in 1-methoxy-2-propanol |

The following TABLE III shows the various iodonium salts used in the invention and comparative Examples.

TABLE III

| | Iodonium salt | |
|---|---|---|
| | **Structure** | **Amount (grams)** |
| Invention Example 1 | 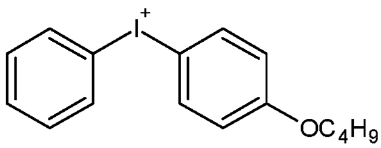 | 0.05 |
| Invention Example 2 | 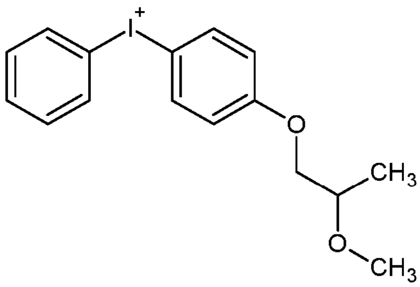 | 0.05 |
| Comparative Example 1 | 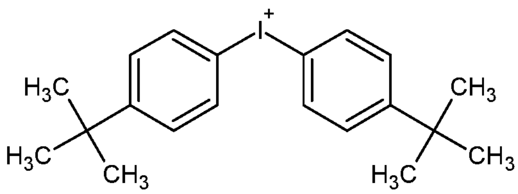 | 0.05 |
| Comparative Example 2 | 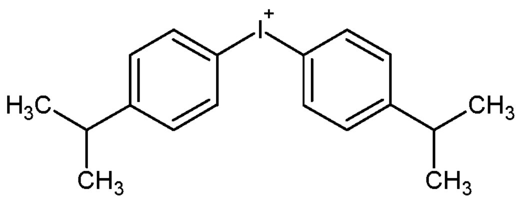 | 0.05 |
| Comparative Example 3 | 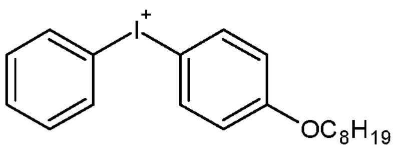 | 0.05 |

(continued)

| | Iodonium salt | |
|---|---|---|
| | Structure | Amount (grams) |
| Comparative Example 4 | 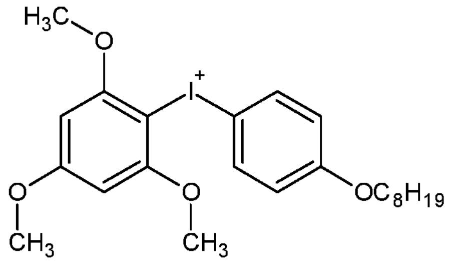 | 0.05 |

On-press Developability (DOP):

Each of the prepared lithographic printing plate precursors was imagewise exposed at 50 to 300 mJ/cm$^2$ using a Kodak Trendsetter 3244x. Each imaged plate precursor was mounted onto a MAN Roland Favorite 04 press machine without developing. Fountain solution (Varn Supreme 6038) and printing ink (Gans Cyan) were supplied, and printing was performed with on-press development. The on-press developability was evaluated by counting the number of printed paper sheets needed to receive a clean background and given one of the following values based on the number of printed paper sheets.

| | |
|---|---|
| + | ≤ 10 sheets |
| 0 | 10-20 sheets |
| - | > 20 sheets |

Press Life:

Each lithographic printing plate was imagewise exposed and developed on-press as described above. The printing press life was evaluated for each lithographic printing plate by determining the number of printed paper sheets when the tonal value measurement, using a Techkon Spectro Dens spectral densitometer, in a 50 % FM20 screen had been reduced to 70% or less of the tonal value measurement obtained on the 1000$^{th}$ sheet, and given the following values.

| | |
|---|---|
| + | > 20,000 impressions |
| 0 | 10,000-20,000 impressions |
| - | < 10,000 impressions |

Print-out:

Each of the lithographic printing plate precursors was imagewise exposed at 50 to 300 mJ/cm2 using a Kodak Trendsetter 3244x as described above. For each imaged precursor, the color difference between exposed and unexposed regions was measured using a Techkon Spectro Dens spectral densitometer, calculating the Euclidean distance of the measured L*a*b values, and given the following values.

| | |
|---|---|
| + | > 7.5 |
| 0 | 7.0 - 7.5 |
| - | < 7.0 |

The results of the various evaluations are provided in the following TABLE IV.

TABLE IV

| | Print-Out | Press Life | DOP |
|---|---|---|---|
| Invention Example 1 | + | + | + |

(continued)

| | Print-Out | Press Life | DOP |
|---|---|---|---|
| Invention Example 2 | + | + | + |
| Comparative Example 1 | 0 | + | + |
| Comparative Example 2 | 0 | + | + |
| Comparative Example 3 | 0 | 0 | + |
| Comparative Example 4 | - | 0 | + |

As can be seen from the data in TABLE IV, the lithographic printing plate precursors of the present invention exhibited excellent print-out, press life, and on-press developability. On the other hand, the lithographic printing plate precursors prepared outside of the present invention, that is Comparative Examples 1, 2, 3, and 4, exhibited poor print-out due to the choice of the iodonium salt in the infrared radiation-sensitive imageable layer.

## Claims

**1.** A lithographic printing plate precursor comprising:

a substrate comprising a hydrophilic surface;
an infrared radiation-sensitive imageable layer that is disposed on the hydrophilic surface of the substrate, the infrared radiation-sensitive imageable layer comprising:

one or more free radically polymerizable components,
an initiator composition that provides free radicals upon exposure of the infrared radiation-sensitive imageable layer to infrared radiation,
one or more infrared radiation absorbers, and
optionally, a polymeric binder different from the one or more free radically polymerizable components; and

optionally, a protective layer disposed over the infrared radiation-sensitive imageable layer;
wherein the initiator composition comprises an iodonium tetraaryl borate that is represented by the following formula (I):

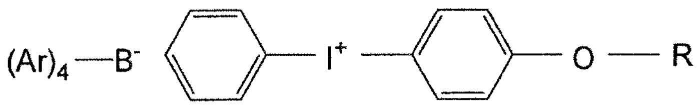

(I)

wherein Ar is independently unsubstituted phenyl or naphthyl groups, or substituted phenyl or naphthyl groups each having one or more electron-donating substituents; and R is a linear or branched organic group comprising 0 to 3 oxygen atoms and 2 to 5 carbon atoms, provided that R is directly attached to the oxygen atom with one of the carbon atoms.

**2.** The lithographic printing plate precursor of claim 1, wherein Ar is the same unsubstituted phenyl group.

**3.** The lithographic printing plate precursor of claim 1 or 2, wherein R is an organic group comprising 0,1, or 2 oxygen atoms and 3 or 4 carbon atoms.

**4.** The lithographic printing plate precursor of any of claims 1 to 3, wherein the iodonium tetraaryl borate is present in an amount of at least 1 weight % and up to and including 25 weight %, based on the total dry weight of the infrared radiation-sensitive imageable layer.

**5.** The lithographic printing plate precursor of any of claims 1 to 4, wherein the iodonium tetraaryl borate is present in

an amount of at least 5 weight % and up to and including 15 weight %, based on the total dry weight of the infrared radiation-sensitive imageable layer.

**6.** The lithographic printing plate precursor of any of claims 1 to 5, wherein the iodonium tetraaryl borate is present in an amount of at least 6 weight % and up to and including 13 weight %, based on the total dry weight of the infrared radiation-sensitive imageable layer.

**7.** The lithographic printing plate precursor of any of claims 1 to 6, wherein the infrared radiation-sensitive imageable layer further comprises a print-out colorant in an amount of at least 1 weight % and up to and including 10 weight %, based on the total dry weight of the infrared radiation-sensitive imageable layer.

**8.** The lithographic printing plate precursor of claim 7, wherein the print-out colorant is an organic dye or an organic dye precursor that has an acid-dissociatable lactone skeleton.

**9.** The lithographic printing plate precursor of any of claims 1 to 8 that is on-press developable using a lithographic printing ink, a fountain solution, or a combination of a lithographic printing ink and a fountain solution.

**10.** The lithographic printing plate precursor of any of claims 1 to 9, wherein the infrared radiation-sensitive imageable layer comprises two or more free radically polymerizable components.

**11.** The lithographic printing plate precursor of any of claims 1 to 10, wherein the infrared radiation-sensitive imageable layer comprises one or more polymeric binders, at least one of which polymeric binders is present as particles having an average particle size of at least 50 nm and up to and including 400 nm.

**12.** The lithographic printing plate precursor of any of claims 1 to 11, further comprising crosslinked polymeric particles having an average diameter of at least 2 μm, which crosslinked polymeric particles are present either only in the infrared radiation-sensitive imageable layer, only the protective layer when present, or in both the infrared radiation-sensitive imageable layer and the protective layer when present.

**13.** A method for forming a lithographic printing plate, comprising:

imagewise exposing a lithographic printing plate precursor according to any of claims 1 to 12 with infrared radiation, to provide imagewise exposed regions and non-imagewise exposed regions in the infrared radiation-sensitive imageable layer, and
removing the non-imagewise exposed regions of the infrared radiation-sensitive imageable layer.

**14.** The method of claim 13, wherein the lithographic printing plate precursor comprises one or more polymeric binders in the infrared radiation-sensitive imageable layer, at least one of which polymeric binders is present as particles having an average diameter of at least 50 nm and up to and including 400 nm, and wherein removing the non-imagewise exposed regions of the infrared radiation-sensitive imageable layer is carried out on-press using a lithographic printing ink, a fountain solution, or a combination of a lithographic printing ink and a fountain solution.

## Patentansprüche

**1.** Ein Lithographie-Druckplattenvorläufer, umfassend:

einen Träger, umfassend eine hydrophile Oberfläche,
eine infrarotstrahlungsempfindliche bebilderbare Schicht, die auf der hydrophilen Oberfläche des Trägers angeordnet ist, wobei die infrarotstrahlungsempfindliche bebilderbare Schicht umfasst:

eine oder mehrere radikalisch polymerisierbare Komponenten;
eine Initiatorzusammensetzung, die freie Radikale bereitstellt, wenn die infrarotstrahlungsempfindliche bebilderbare Schicht Infrarotstrahlung ausgesetzt wird,
einen oder mehrere Infrarotstrahlungsabsorber, und
gegebenenfalls ein polymeres Bindemittel, das sich von der einen oder den mehreren radikalisch polymerisierbaren Komponenten unterscheidet; und

gegebenenfalls eine Schutzschicht, die über der infrarotstrahlungsempfindlichen bebilderbaren Schicht angeordnet ist;
wobei die Initiatorzusammensetzung ein Iodoniumtetraarylborat umfasst, das durch die nachstehende Formel (I) dargestellt ist:

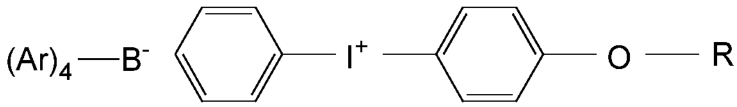

(I)

wobei Ar unabhängig unsubstituierte Phenyl- oder Naphthylgruppen oder substituierte Phenyl- oder Naphthylgruppen darstellt, wobei jede einen oder mehrere Elektronen abgebende Substituenten aufweist; und R eine gerade oder verzweigte organische Gruppe ist, die 0 bis 3 Sauerstoffatome und 2 bis 5 Kohlenstoffatome umfasst, mit der Maßgabe, dass R mit einem der Kohlenstoffatome direkt an das Sauerstoffatom gebunden ist.

**2.** Der Lithographie-Druckplattenvorläufer nach Anspruch 1, wobei Ar dieselbe unsubstituierte Phenylgruppe ist.

**3.** Der Lithographie-Druckplattenvorläufer nach Anspruch 1 oder 2, wobei R eine organische Gruppe ist, die 0, 1 oder 2 Sauerstoffatome und 3 oder 4 Kohlenstoffatome umfasst.

**4.** Der Lithographie-Druckplattenvorläufer nach einem der Ansprüche 1 bis 3, wobei das Iodoniumtetraarylborat in einer Menge von mindestens 1 Gew.-% und bis zu und einschließlich 25 Gew.-%, bezogen auf das Gesamttrockengewicht der infrarotstrahlungsempfindlichen bebilderbaren Schicht, vorliegt.

**5.** Der Lithographie-Druckplattenvorläufer nach einem der Ansprüche 1 bis 4, wobei das Iodoniumtetraarylborat in einer Menge von mindestens 5 Gew.-% und bis zu und einschließlich 15 Gew.-%, bezogen auf das Gesamttrockengewicht der infrarotstrahlungsempfindlichen bebilderbaren Schicht, vorliegt.

**6.** Der Lithographie-Druckplattenvorläufer nach einem der Ansprüche 1 bis 5, wobei das Iodoniumtetraarylborat in einer Menge von mindestens 6 Gew.-% und bis zu und einschließlich 13 Gew.-%, bezogen auf das Gesamttrockengewicht der infrarotstrahlungsempfindlichen bebilderbaren Schicht, vorliegt.

**7.** Der Lithographie-Druckplattenvorläufer nach einem der Ansprüche 1 bis 6, wobei die infrarotstrahlungsempfindliche bebilderbare Schicht ferner ein Print-out Farbmittel in einer Menge von mindestens 1 Gew.-% und bis zu und einschließlich 10 Gew.-%, bezogen auf das Gesamttrockengewicht der infrarotstrahlungsempfindlichen bebilderbaren Schicht, umfasst.

**8.** Der Lithographie-Druckplattenvorläufer nach Anspruch 7, wobei es sich bei dem Print-out Farbmittel um einen organischen Farbstoff oder einen organischen Farbstoffvorläufer handelt, der ein säuredissoziierbares Lactongerüst aufweist.

**9.** Der Lithographie-Druckplattenvorläufer nach einem der Ansprüche 1 bis 8, der auf der Druckpresse unter Verwendung einer lithographischen Druckfarbe, eines Feuchtmittels oder einer Kombination aus einer lithographischen Druckfarbe und eines Feuchtmittels entwickelbar ist.

**10.** Der Lithographie-Druckplattenvorläufer nach einem der Ansprüche 1 bis 9, wobei die infrarotstrahlungsempfindliche bebilderbare Schicht zwei oder mehr radikalisch polymerisierbare Komponenten umfasst.

**11.** Der Lithographie-Druckplattenvorläufer nach einem der Ansprüche 1 bis 10, wobei die infrarotstrahlungsempfindliche bebilderbare Schicht ein oder mehrere polymere Bindemittel umfasst, wobei mindestens eines der polymeren Bindemittel in Form von Teilchen mit einer durchschnittlichen Teilchengröße von mindestens 50 nm und bis zu und einschließlich 400 nm vorliegt.

**12.** Der Lithographie-Druckplattenvorläufer nach einem der Ansprüche 1 bis 11, ferner umfassend vernetzte Polymerteilchen mit einem durchschnittlichen Durchmesser von mindestens 2 $\mu$m, wobei die vernetzten Polymerteilchen entweder nur in der infrarotstrahlungsempfindlichen bebilderbaren Schicht, nur in der Schutzschicht, wenn vorhanden, oder sowohl in der infrarotstrahlungsempfindlichen bebilderbaren Schicht als auch in der Schutzschicht, wenn vorhanden, vorliegt.

**13.** Ein Verfahren zur Bildung einer Lithographie-Druckplatte, umfassend:

bildweises Belichten eines Lithographie-Druckplattenvorläufers nach einem der Ansprüche 1 bis 12 mit Infrarotstrahlung, um bildweise belichtete Bereiche und nicht bildweise belichtete Bereiche in der infrarotstrahlungsempfindlichen bebilderbaren Schicht bereitzustellen, und
Entfernen der nicht bildweise belichteten Bereiche der infrarotstrahlungsempfindlichen bebilderbaren Schicht.

**14.** Das Verfahren nach Anspruch 13, wobei der Lithographie-Druckplattenvorläufer ein oder mehrere polymere Bindemittel in der infrarotstrahlungsempfindlichen bebilderbaren Schicht umfasst, wobei mindestens eines der polymeren Bindemittel in Form von Teilchen mit einem durchschnittlichen Durchmesser von mindestens 50 nm und bis zu und einschließlich 400 nm vorliegt, und
wobei das Entfernen der nicht bildweise belichteten Bereiche der infrarotstrahlungsempfindlichen bebilderbaren Schicht auf der Druckpresse unter Verwendung einer lithographischen Druckfarbe, eines Feuchtmittels oder einer Kombination aus einer lithographischen Druckfarbe und eines Feuchtmittels durchgeführt wird.

## Revendications

**1.** Précurseur de plaque d'impression lithographique comprenant :

un substrat comprenant une surface hydrophile ;
une couche imageable sensible au rayonnement infrarouge disposée sur la surface hydrophile du substrat, la couche imageable sensible au rayonnement infrarouge comprenant :

un ou plusieurs composants polymérisables par radicaux libres,
une composition d'initiateur qui fournit des radicaux libres lors de l'exposition de la couche imageable sensible au rayonnement infrarouge à un rayonnement infrarouge,
un ou plusieurs absorbeurs de rayonnement infrarouge et, éventuellement, un liant polymère différent du ou des composants polymérisables par radicaux libres ; et
éventuellement, une couche de protection disposée sur la couche imageable sensible au rayonnement infrarouge ;

dans lequel la composition d'initiateur comprend un borate de tétraaryle d'iodonium qui est représenté par la formule suivante (I) :

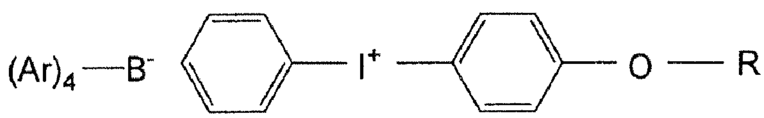

(I)

où Ar désigne indépendamment des groupes phényle ou naphtyle non substitués, ou des groupes phényle ou naphtyle substitués ayant chacun un ou plusieurs substituants donneurs d'électrons ; et R désigne un groupe organique linéaire ou ramifié comprenant de 0 à 3 atomes d'oxygène et de 2 à 5 atomes de carbone, à condition que R soit directement lié à l'atome d'oxygène par l'un des atomes de carbone.

**2.** Précurseur de plaque d'impression lithographique selon la revendication 1, dans lequel Ar est le même groupe phényle non substitué.

**3.** Précurseur de plaque d'impression lithographique selon la revendication 1 ou 2, dans lequel R est un groupe organique comprenant 0, 1, ou 2 atomes d'oxygène et 3 ou 4 atomes de carbone.

**4.** Précurseur de plaque d'impression lithographique selon l'une quelconque des revendications 1 à 3, dans lequel le borate de tétraaryle d'iodonium est présent à raison d'au moins 1 % en poids et jusqu'à et y compris 25 % en poids

sur la base du poids sec total de la couche imageable sensible au rayonnement infrarouge.

**5.** Précurseur de plaque d'impression lithographique selon l'une quelconque des revendications 1 à 4, dans lequel le borate de tétraaryle d'iodonium est présent à raison d'au moins 5 % en poids et jusqu'à et y compris 15 % en poids sur la base du poids sec total de la couche imageable sensible au rayonnement infrarouge.

**6.** Précurseur de plaque d'impression lithographique selon l'une quelconque des revendications 1 à 5, dans lequel le borate de tétraaryle d'iodonium est présent à raison d'au moins 6 % en poids et jusqu'à et y compris 13 % en poids sur la base du poids sec total de la couche imageable sensible au rayonnement infrarouge.

**7.** Précurseur de plaque d'impression lithographique selon l'une quelconque des revendications 1 à 6, dans lequel la couche imageable sensible au rayonnement infrarouge comprend en outre un colorant d'impression à raison d'au moins 1 % en poids et jusqu'à et y compris 10 % en poids sur la base du poids sec total de la couche imageable sensible au rayonnement infrarouge.

**8.** Précurseur de plaque d'impression lithographique selon la revendication 7, dans lequel le colorant d'impression est un colorant organique ou un précurseur de colorant organique ayant un squelette lactone dissociable par un acide.

**9.** Précurseur de plaque d'impression lithographique selon l'une quelconque des revendications 1 à 8, qui est développable sur presse à l'aide d'une encre d'impression lithographique, d'une solution de mouillage, ou à la fois d'une encre d'impression lithographique et d'une solution de mouillage.

**10.** Précurseur de plaque d'impression lithographique selon l'une quelconque des revendications 1 à 9, dans lequel la couche imageable sensible au rayonnement infrarouge comprend au moins deux composants polymérisables par radicaux libres.

**11.** Précurseur de plaque d'impression lithographique selon l'une quelconque des revendications 1 à 10, dans lequel la couche imageable sensible au rayonnement infrarouge comprend un ou plusieurs liants polymères, au moins un desdits liants polymères étant présent sous forme de particules ayant une granulométrie moyenne d'au moins 50 nm et jusqu'à et y compris 400 nm.

**12.** Précurseur de plaque d'impression lithographique selon l'une quelconque des revendications 1 à 11, comprenant en outre des particules polymères réticulées ayant un diamètre moyen d'au moins 2 $\mu$m, lesdites particules polymères réticulées étant présentes uniquement dans la couche imageable sensible au rayonnement infrarouge ou uniquement dans la couche de protection si présente, ou à la fois dans la couche imageable sensible au rayonnement infrarouge et dans la couche de protection si présente.

**13.** Procédé de formation d'une plaque d'impression lithographique, comprenant :

l'exposition selon une image d'un précurseur de plaque d'impression lithographique selon l'une quelconque des revendications 1 à 12 à un rayonnement infrarouge afin de former des régions exposées selon une image et des régions non exposées selon une image dans la couche imageable sensible au rayonnement infrarouge, et l'élimination des régions non-exposées selon une image de la couche imageable sensible au rayonnement infrarouge.

**14.** Procédé selon la revendication 13, dans lequel le précurseur de plaque d'impression lithographique comprend un ou plusieurs liants polymères dans la couche imageable sensible au rayonnement infrarouge, au moins un desdits liants polymères étant présent sous forme de particules ayant un diamètre moyen d'au moins 50 nm et jusqu'à et y compris 400 nm, et
dans lequel les régions non exposées selon une image de la couche imageable sensible au rayonnement infrarouge sont éliminées sur presse à l'aide d'une encre d'impression lithographique, d'une solution de mouillage, ou à la fois d'une encre d'impression lithographique et d'une solution de mouillage.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 7524614 B, Tao
- US 20110003123, Simpson
- US 20090047599, Home
- US 20130052582 A, Hayashi
- EP 1182033 A1, Fujimaki
- US 6309792 B, Hauck
- US 6569603 B, Furukawa
- US 6893797 B, Munnelly
- US 20090142695, Baumann
- US 5208135 A, Patel
- US 6153356 A, Urano
- US 6797449 B, Nakamura
- US 7018775 B, Tao
- US 7368215 B, Munnelly
- US 8632941 B, Balbinot
- US 2007056457, Iwai
- US 2011003123 A, Simpson
- US 6899994 B, Huang
- WO 2015156065 A, Kamiya
- US 7261998 B, Hayashi
- US 20150099229, Simpson
- US 6916595 B, Fujimaki
- US 6858374 B, Yanaka
- US 64287615, Hayakawa
- US 8383319 B, Huang
- US 8105751 B, Endo
- US 7429445 B, Munnelly
- US 20130323643, Balbinot
- EP 1765593 A


### Non-patent literature cited in the description


- Pure Appl. Chem. International Union of Pure and Applied Chemistry, 1996, vol. 68, 2287-2311
- **A REISER.** Photoreactive Polymers: The Science and Technology of Resists. Wiley, 1989, 102-177
- **B.M. MONROE.** Radiation Curing: Science and Technology. Plenum, 1992, 399-440
- Polymer Imaging. **A.B. COHEN ; P. WALKER et al.** Imaging Processes and Material. Van Nostrand Reinhold, 1989, 226-262